(19)

**Europäisches Patentamt**
**European Patent Office**
**Office européen des brevets**

(11)     **EP 1 419 576 B1**

(12)                **EUROPÄISCHE PATENTSCHRIFT**

(45) Veröffentlichungstag und Bekanntmachung des Hinweises auf die Patenterteilung:
**05.11.2008 Patentblatt 2008/45**

(21) Anmeldenummer: **02755488.0**

(22) Anmeldetag: **02.08.2002**

(51) Int Cl.:
***H03H 9/17*** *(2006.01)*

(86) Internationale Anmeldenummer:
**PCT/IB2002/003263**

(87) Internationale Veröffentlichungsnummer:
**WO 2003/017480 (27.02.2003 Gazette 2003/09)**

(54) **FILTERANORDNUNG MIT VOLUMENWELLEN-RESONATOR**

FILTER SYSTEM COMPRISING A BULK ACOUSTIC WAVE RESONATOR

ENSEMBLE FILTRE COMPORTANT UN RESONATEUR A ONDES DE VOLUME

(84) Benannte Vertragsstaaten:
**AT BE BG CH CY CZ DE DK EE ES FI FR GB GR IE IT LI LU MC NL PT SE SK TR**

(30) Priorität: **14.08.2001 EP 01306932**

(43) Veröffentlichungstag der Anmeldung:
**19.05.2004 Patentblatt 2004/21**

(73) Patentinhaber: **NXP B.V.**
**5656 AG Eindhoven (NL)**

(72) Erfinder:
• **LOEBL, Hans, P.**
**NL-5656 AA Eindhoven (NL)**
• **KLEE, Mareike, K.**
**NL-5656 AA Eindhoven (NL)**
• **MILSOM, Robert, F.**
**NL-5656 AA Eindhoven (NL)**
• **METZMACHER, Christof**
**NL-5656 AA Eindhoven (NL)**
• **BRAND, Wolfgang**
**NL-5656 AA Eindhoven (NL)**

(74) Vertreter: **White, Andrew Gordon et al**
**NXP Semiconductors**
**Intellectual Property Department**
**Cross Oak Lane**
**Redhill**
**Surrey RH1 5HA (GB)**

(56) Entgegenhaltungen:
**EP-A- 0 609 555          US-A- 6 087 198**

**Beschreibung**

Die Erfindung betrifft Filteranordnung ausgestattet mit wenigstens einem Volumenwellen-Resonator, welcher eine Resonatoreinheit und ein Reflexionselement enthält. Weiterhin betrifft die Erfindung noch ein drahtloses Datenübertragungssystem, einen Sender, einen Empfänger sowie ein Mobilfunkgerät ausgerüstet mit einer Filteranordnung. Die Erfindung betrifft auch einen Volumenwellen-Resonator.

Die rasanten Entwicklungen im Mobilfunkbereich und die stete Miniaturisierung der schnurlosen Telefonapparate führen zu erhöhten Anforderungen an die einzelnen Komponenten. So ist eine hohe Selektivität im Hochfrequenzteil nötig, um den Empfänger gegen die steigende Anzahl möglicherweise störender Signale von anderen Systemen zu schützen. Dies wird beispielsweise durch Bandpassfilter erreicht, die nur ein begrenztes Frequenzband durchlassen und alle Frequenzen ober- und unterhalb dieses Bereiches unterdrücken.

Ein derartiger Filter kann beispielsweise ein Volumenwellen-Filter aus Volumenwellen-Resonatoren, die auch als Bulk Acoustic Wave (BAW) Filter bezeichnet werden, sein. Volumenwellen-Resonatoren sind prinzipiell aus drei Komponenten aufgebaut. Die erste Komponente generiert die akustische Welle und enthält eine piezoelektrische Schicht. Zwei Elektroden, welche ober- und unterhalb der piezoelektrischen Schicht angebracht sind, stellen die zweite Komponente dar. Die dritte Komponente, d. h. das Reflexionselement, hat die Aufgabe das Substrat von den Schwingungen, die die piezoelektrische Schicht erzeugt, akustisch zu isolieren.

Eine Möglichkeit zur akustischen Isolation des Substrats von den Schwingungen der piezoelektrischen Schicht sind akustische Interferenzfilter, welche mehrere $\lambda/4$-Schichten aus Materialien mit hoher und niedriger akustischer Impedanz umfassen. Ein derartiger Volumenwellen-Resonator ist beispielsweise aus der US 5,646,583 oder EP-A-609 555 bekannt.

Besonders im Durchlassbandes einer aus Volumenwellen-Resonatoren aufgebauten Filteranordnung wird eine gute akustische Entkopplung der Volumenwellen-Resonatoren vom Substrat benötigt, um eine große Güte des Volumenwellen-Resonatoren zu erreichen.

Es ist deshalb eine Aufgabe der Erfindung, eine Filteranordnung mit wenigstens einem Volumenwellen-Resonator bereitzustellen, der insbesondere im Durchlassbandes der Filteranordnung eine effiziente akustische Isolation des Substrats von den Schwingungen der piezoelektrischen Schicht aufweist.

Diese Aufgabe wird gelöst durch eine Filteranordnung ausgestattet mit wenigstens einem Volumenwellen-Resonator, welcher eine Resonatoreinheit und ein Reflexionselement enthält, wobei das Reflexionselement mehrere Schichten umfasst, die jeweils eine Mischung aus wenigstens zwei Materialien enthalten, wobei innerhalb jeder Schicht die Zusammensetzung der Mischung relativ zur Schichtdicke kontinuierlich und periodisch variiert.

Derartige Filteranordnungen weisen im Durchlassbandes der Volumenwellen-Filteranordnung eine gute akustische Entkopplung der Volumenwellen-Resonatoren vom Substrat auf. Außerdem zeigt das Reflexionselement außerhalb des Durchlassbandes eine hohe Transmission für Schallwellen, so dass die Volumenwellen-Filteranordnung in diesem Bereich gut an das Substrat angekoppelt ist. Dadurch werden höhere harmonische Frequenzen außerhalb des Durchlassbandes sehr effektiv unterdrückt und die Filteranordnung weist dort keine unerwünschten Resonanzen auf. Insgesamt weist eine derartige Filteranordnung ein klar definiertes Stopband auf.

Es ist bevorzugt, dass das Reflexionselement eine Mischung aus $SiO_2$ und $Ta_2O_5$ oder $SiO_2$ und $Si_3N_4$ enthält.

Diese Materialien und Mischungen dieser Materialien sind alle sehr gut elektrisch isolierend und können leicht hergestellt und auf einem Substrat aufgebracht werden.

Außerdem betrifft die Erfindung einen Sender, einen Empfänger, ein Mobilfunkgerät und ein drahtloses Datenübertragungssystem ausgerüstet mit einer Filteranordnung mit wenigstens einem Volumenwellen-Resonator, welcher eine Resonatoreinheit und ein Reflexionselement enthält, wobei das Reflexionselement mehrere Schichten umfasst, die jeweils eine Mischung aus wenigstens zwei Materialien enthalten, wobei innerhalb jeder Schicht die Zusammensetzung der Mischung relativ zur Schichtdicke kontinuierlich und periodisch variiert. Die Erfindung betrifft auch einen Volumenwellen-Resonator, welcher eine Resonatoreinheit und ein Reflexionselement enthält, wobei das Reflexionselement mehrere Schichten umfasst, die jeweils eine Mischung aus wenigstens zwei Materialien enthalten, wobei innerhalb jeder Schicht die Zusammensetzung der Mischung relativ zur Schichtdicke kontinuierlich und periodisch variiert.

Im folgenden soll die Erfindung anhand von fünf Figuren und drei Ausführungsbeispielen näher erläutert werden. Dabei zeigt

Fig. 1 im Querschnitt den Aufbau eine Filteranordnung aus Volumenwellen-Resonatoren,

Fig. 2 die periodische Variation der Zusammensetzung einer Mischung aus wenigstens zwei Materialien im Reflexionselement einer Volumenwellen-Filteranordnung

Fig. 3 das Reflexionsverhalten eines Reflexionselementes aus Interferenzschichten,

Fig. 4, Fig. 5 das Reflexionsverhalten erfindungsgemäßer Reflexionselemente.

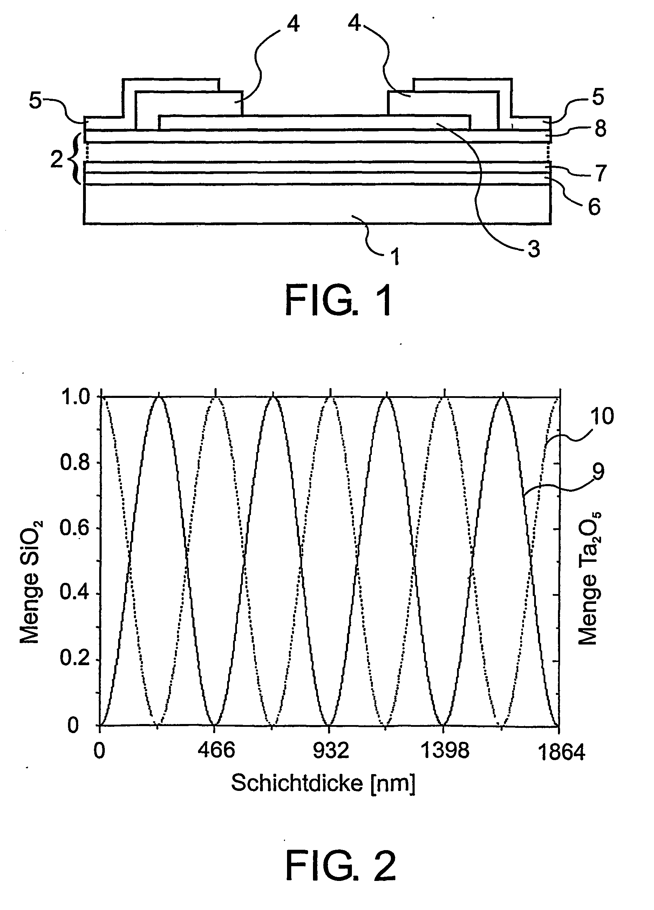

Gemäß Fig. 1 weist eine Volumenwellen-Filteranordnung ein Substrat 1 auf, welches zum Beispiel aus einem keramischen Material, einem keramischen Material mit einer Planarisierungsschicht aus Glas, einem glaskeramischen Material, einem Glasmaterial, einem halbleitenden Material, wie beispielsweise Silicium, GaAs, InP, SiC oder GaN, oder Saphir ist. Bei Verwendung von einem halbleitenden Material als Substrat 1 kann noch eine Passivierungsschicht aus beispielsweise $SiO_2$ oder Glas aufgebracht werden. Auf dem Substrat 1 befindet sich ein Reflexionselement 2. Das Reflexionselement 2 umfasst mehrere Schichten 6, 7, 8. Die Gesamtanzahl der Schichten des Reflexionselementes 2 liegt vorzugsweise zwischen 3 und 12. Die Schichten 6, 7, 8 des Reflexionselementes 2 enthalten eine Mischung aus wenigstens zwei Materialien. Vorzugsweise enthalten die Schichten 6, 7, 8 eine Mischung aus $SiO_2$ und $Ta_2O_5$ oder $SiO_2$ und $Si_3N_4$. Es ist vorteilhaft, dass die Mischung eine amorphe Mischung ist. Die Zusammensetzung innerhalb einer Schicht variiert kontinuierlich und periodisch, beispielsweise sinusförmig mit der Schichtdicke d als Periode, relativ zur Richtung der Schichtdicke d, wie in Fig. 2 gezeigt. Die Schichtdicke d jeder Schicht ergibt sich nach der Formel

$$d = \frac{(v_{Material\ 1} + v_{Material\ 2})}{4 f_c}$$

wobei $v_{Material1}$ die Schallgeschwindigkeit des ersten Materials der Mischung, $v_{Material2}$ die Schallgeschwindigkeit des zweiten Materials des Mischung und $f_c$ die Arbeitsfrequenz der Volumenwellen-Filteranordnung, bei der die Reflexion des Reflexionselementes 2 100 % sein soll, ist.

Auf dem Reflexionselement 2 sind Resonatoreinheiten aufgebracht, welche jeweils eine erste Elektrode 3, eine piezoelektrische Schicht 4 und eine zweite Elektrode 5 enthalten. Die Elektroden 3 und 5 sind vorzugsweise aus einem gut leitendem Material mit geringer akustischer Dämpfung.

Als Material für die piezoelektrische Schicht 4 kann zum Beispiel AlN, ZnO, $Pb(Zn_{1/3}Nb_{2/3})O_3$-$PbTiO_3$, $Pb(Mg_{1/3}Nb_{2/3})O_3$-$PbTiO_3$, $Pb(Ni_{1/3}Nb_{2/3})O_3$-$PbTiO_3$, $Pb(Sc_{1/3}Nb_{2/3})O_3$-$PbTiO_3$, $Pb(Zn_{1/3}Nb_{2/3})_{1-x-y}(Mn_{1/2}Nb_{1/2})_xTi_yO_3$ $(0 \leq x \leq 1, 0 \leq y \leq 1)$, $Pb(In_{1/2}Nb_{1/2})O_3$-$PbTiO_3$, $Sr_3TaGa_3Si_2O_{14}$, $K(Sr_{1-x}Ba_x)_2Nb_5O_{15}$ $(0 \leq x \leq 1)$, $Na(Sr_{1-x}Ba_x)_2Nb_5O_{15}$ $(0 \leq x \leq 1)$, $BaTiO_3$, $(K_{1-x}Na_x)NbO_3$ $(0 \leq x \leq 1)$, $KTaO_3$, $(Bi,Na,K,Pb,Ba)TiO_3$, $(Bi,Na)TiO_3$, $Bi_7Ti_4NbO_{21}$, $(K_{1-x}Na_x)NbO_3$-$(Bi,Na,K,Pb,Ba)TiO_3$ $(0 \leq x \leq 1)$, $a(Bi_xNa_{1-x})TiO_{3-b}(KNbO_{3-c})$½$(Bi_2O_3$-$Sc_2O_3)$ $(0 \leq x \leq 1, a + b + c = 1)$, $(Ba_aSr_bCa_c)Ti_xZr_{1-x}O_3$ $(0 \leq x \leq 1, a + b + c = 1)$, $(Ba_aSr_bLa_c)Bi_4Ti_4O_{15}$ $(a + b + c = 1)$, $Bi_4Ti_3O_{12}$, $LiNbO_3$, $La_3Ga_{5.5}Nb_{0.5}O_{14}$, $La_3Ga_5SiO_{14}$, $La_3Ga_{5.5}Ta_{0.5}O_{14}$ und $PbZr_xTi_{1-x}O_3$ $(0 \leq x \leq 1)$ mit und ohne Dotierungen aus La, Mn, Fe, Sb, Sr, Ni oder Kombinationen dieser Dotierungsmittel verwendet werden.

Über der Filteranordnung kann eine Schutzschicht aus einem organischen oder einem anorganischen Material oder einer Kombination aus diesen Materialien aufgebracht sein. Als organisches Material kann beispielsweise Polybenzocyclobuten oder Polyimid und als anorganisches Material kann zum Beispiel $Si_3N_4$, $SiO_2$ oder $Si_xO_yN_z$ $(0 \leq x \leq 1, 0 \leq y \leq 1, 0 \leq z \leq 1)$ verwendet werden. Alternativ kann auf einem oder mehreren Volumenwellen-Resonatoren der Filteranordnung eine dünne Schicht aus $SiO_2$ zur gezielten Verstimmung des Volumenwellen-Resonators aufgebracht werden. Es kann bevorzugt sein, dass die dünne Schicht aus $SiO_2$ nur auf der zweiten Elektrode 5 eines Volumenwellen-Resonators aufgebracht ist. Die Schichtdicke der dünnen Schicht aus $SiO_2$ beträgt vorzugsweise zwischen 10 und 100 nm.

Die Herstellung eines Reflexionselementes 2, welches Schichten 6, 7, 8 aus einer Mischung, deren Zusammensetzung kontinuierlich und periodisch variiert, enthält, kann beispielsweise mittels Plasma-unterstützter Gasphasenabscheidung (PECVD) erfolgen. Zur Herstellung von Schichten 6, 7, 8, welche $SiO_2$ und $Ta_2O_5$ enthalten, wird kontinuierlich periodisch die Menge der zugeführten Gase, beispielsweise $Si(OC_2H_5)_4$, $Ta(OC_2H_5)_5$ und $O_2$, variiert. Zur Herstellung von Schichten 6, 7, 8, welche $SiO_2$ und $Si_3N_4$ enthalten, wird kontinuierlich periodisch die Menge der zugeführten Gase, beispielsweise $SiH_4$, $N_2O$ und $NH_3$, variiert.

Eine erfindungsgemäße Filteranordnung kann beispielsweise zur Signalfilterung in einem drahtlosen Datenübertragungssystem, in einem Mobilfunkgerät, in einem Sender oder in einem Empfänger verwendet werden.

Im folgenden werden Ausführungsformen der Erfindung erläutert, die beispielhafte Realisierungsmöglichkeiten darstellen.

Ausführungsbeispiel 1 (Vergleichsbeispiel)

Auf einem Substrat 1 aus Silicium ist eine Filteranordnung aus Volumenwellen-Resonatoren mit einem Reflexionselement 2 aus Interferenzschichten aufgebracht. Dazu wurde auf dem Substrat 1 ein Reflexionselement 2, welches sieben Schichten aus abwechselnd $SiO_2$ und $Ta_2O_5$ enthält, aufgebracht. Dabei enthält die erste Schicht 6 auf dem Substrat 1 $SiO_2$. Die Schichtdicke der Schichten mit $SiO_2$ betrug 524 nm und die Schichtdicke der Schichten mit $Ta_2O_5$ betrug 409 nm. Auf der obersten Schicht 8 des Reflexionselements 2, welche $SiO_2$ enthält, befinden sich die einzelnen Volumenwellen-Resonatoren, die jeweils eine erste Elektrode 3, eine piezoelektrische Schicht 4 und eine zweite Elektrode 5 umfassen. Die erste Elektrode 3 enthält Al mit einer Schichtdicke von 300 nm Auf jeder ersten Elektrode 3 ist als piezoelektrische Schicht 4 eine 1381 nm dicke Schicht aus AlN aufgebracht. Auf jeder piezoelektrischen Schicht 4 befindet sich eine 150 nm dicke zweite Elektrode 5 aus Al. Die einzelnen Volumenwellen-Resonatoren sind auf dem Substrat 1 derart elektrisch verbunden, dass eine Filteranordnung für die Frequenz 2.85 GHz erhalten wurde.

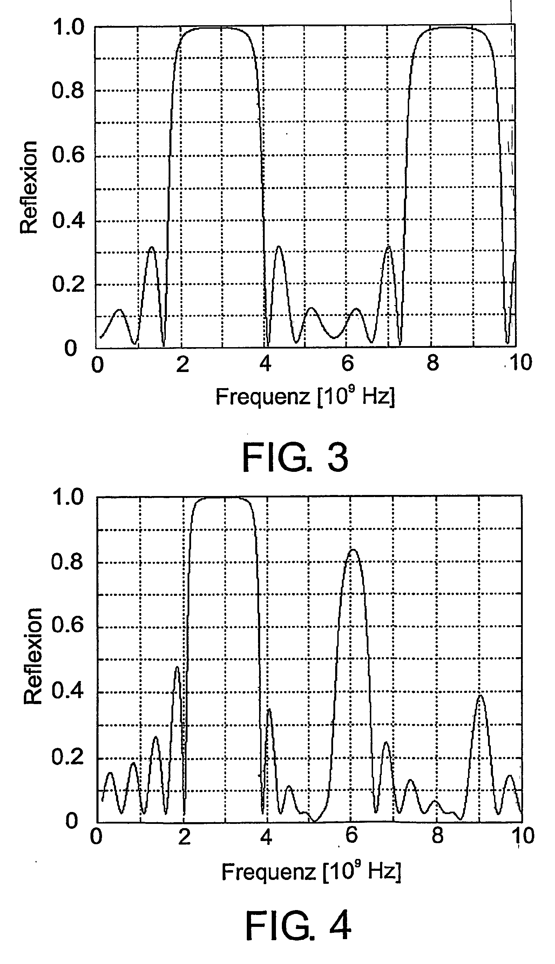

In Fig. 3 ist das Reflexionsverhalten des Reflexionselementes 2 dieser Filteranordnung gezeigt.

Ausführungsbeispiel 2

Auf einem Substrat 1 aus Silicium ist eine Filteranordnung aus Volumenwellen-Resonatoren mit einem Reflexionselement 2 aufgebracht. Dazu wurde auf dem Substrat 1 ein Reflexionselement 2, welches zehn Schichten enthält, aufgebracht. Dabei enthält jede Schicht eine Mischung aus $SiO_2$ und $Ta_2O_5$, wobei die Menge an jeder Komponente in einer Schicht 6, 7, 8 sinusförmig mit der Schichtdicke d einer Schicht 6, 7, 8 als Periode variierte. Fig. 2 zeigt die Zusammensetzung innerhalb der Schichten 6, 7, 8 relativ zur Schichtdicke. Dabei entspricht die Kurve 9 $Ta_2O_5$ und die Kurve 10 $SiO_2$. Die Schichtdicke d jeder Schicht 6, 7, 8 betrug 466 nm. Auf der obersten Schicht 8 des Reflexionselements 2 befinden sich die einzelnen Volumenwellen-Resonatoren, die jeweils eine erste Elektrode 3, eine piezoelektrische Schicht 4 und eine zweite Elektrode 5 umfassen. Die erste Elektrode 3 enthält Al mit einer Schichtdicke von 200 nm. Auf jeder ersten Elektrode 3 ist als piezoelektrische Schicht 4 eine 1679 nm dicke Schicht aus AlN aufgebracht Auf jeder piezoelektrischen Schicht 4 befindet sich eine 200 nm dicke zweite Elektrode 5 aus Al. Die einzelnen Volumenwellen-Resonatoren sind auf dem Substrat 1 derart elektrisch verbunden, dass eine Filteranordnung für die Frequenz 2.85 GHz erhalten wurde.

In Fig. 4 ist das Reflexionsverhalten des Reflexionselementes 2 dieser Filteranordnung gezeigt. Eine derartige Filteranordnung wurde Signalfilterung im Hochfrequenzteil eines Mobilfunkgerätes verwendet

Ausführungsbeispiel 3

Auf einem Substrat 1 aus Silicium ist eine Filteranordnung aus Volumenwellen-Resonatoren mit einem Reflexionselement 2 aufgebracht Dazu wurde auf dem Substrat 1 ein Reflexionselement 2, welches zehn Schichten enthält, aufgebracht. Dabei enthält jede Schicht eine Mischung aus $SiO_2$ und $Si_3N_4$, wobei die Menge an jeder Komponente in einer Schicht 6, 7, 8 sinusförmig mit der Schichtdicke d als Periode variierte. Die Schichtdicke d jeder Schicht 6, 7, 8 betrug 744 nm. Auf der obersten Schicht 8 des Reflexionselements 2 befinden sich die einzelnen Volumenwellen-Resonatoren, die jeweils eine erste Elektrode 3, eine piezoelektrische Schicht 4 und eine zweite Elektrode 5 umfassen. Die erste Elektrode 3 enthält Al mit einer Schichtdicke von 200 nm Auf jeder ersten Elektrode 3 ist als piezoelektrische Schicht 4 eine 1650 nm dicke Schicht aus AlN aufgebracht. Auf jeder piezoelektrischen Schicht 4 befindet sich eine 200 nm dicke zweite Elektrode 5 aus Al. Die einzelnen Volumenwellen-Resonatoren sind auf dem Substrat 1 derart elektrisch verbunden, dass eine Filteranordnung für die Frequenz 2.85 GHz erhalten wurde.

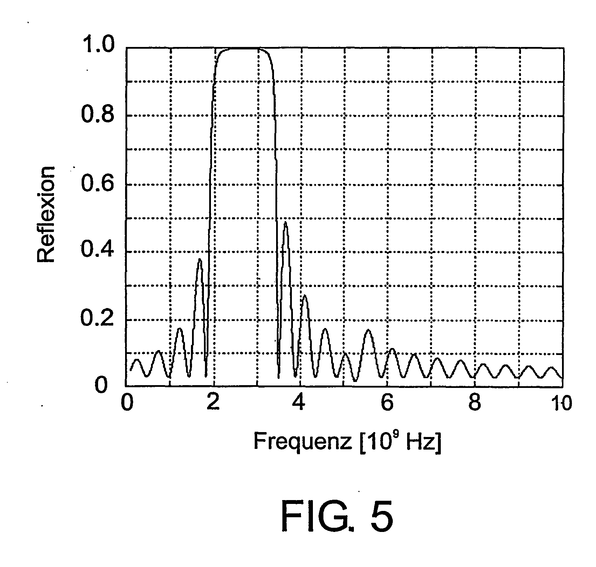

In Fig. 5 ist das Reflexionsverhalten des Reflexionselementes 2 dieser Filteranordnung gezeigt. Eine derartige Filteranordnung wurde Signalfilterung im Hochfrequenzteil eines Mobilfunkgerätes verwendet.

**Patentansprüche**

1. Volumenwellen-Resonator, welcher eine Resonatoreinheit und ein Reflexionselement (2) enthält, wobei das Reflexionselement (2) mehrere Schichten (6, 7, 8) umfasst, die jeweils eine Mischung aus wenigstens zwei Materialien enthalten, **dadurch gekennzeichnet, dass** innerhalb jeder Schicht (6, 7, 8) die Zusammensetzung der Mischung relativ zur Schichtdicke kontinuierlich und periodisch variiert.

2. Filteranordnung ausgestattet mit wenigstens einem Volumenwellen-Resonator, welcher eine Resonatoreinheit und ein Reflexionselement (2) enthält, **gekennzeichnet durch** die Merkmale von Anspruch 1.

3. Filteranordnung nach Anspruch 2, **dadurch gekennzeichnet, dass** das Reflexionselement (2) eine Mischung aus $SiO_2$ und $Ta_2O_5$ oder $SiO_2$ und $Si_3N_4$ enthält.

4. Mobilfunkgerät ausgerüstet mit einer Filteranordnung **gekennzeichnet durch** die Merkmalen von Anspruch 2 oder Anspruch 3.

5. Sender ausgerüstet mit einer Filteranordnung **gekennzeichnet durch** die Merkmalen von Anspruch 2 oder Anspruch 3.

6. Empfänger ausgerüstet mit einer Filteranordnung **gekennzeichnet durch** die Merkmalen von Anspruch 2 oder Anspruch 3.

7. Drahtloses Datenübertragungssystem ausgerüstet mit einer **gekennzeichnet durch** die Merkmalen von Anspruch 2 oder Anspruch 3.

**Claims**

1. A bulk wave resonator comprising a resonator unit and a reflection element (2), which reflection element (2) comprises several layers (6, 7, 8) which each comprise a mixture of at least two materials, **characterized in that** within each layer (6, 7, 8) the composition of the mixture varies continuously and periodically relative to the layer thickness.

2. A filter device equipped with at least one bulk wave resonator, which comprises a resonator unit and a reflection element (2), **characterized by** the characteristic features as claimed in claim 1.

**3.** A filter device as claimed in claim 2, **characterized in that** the reflection element (2) comprises a mixture of $SiO_2$ and $Ta_2O_5$ or $SiO_2$ and $Si_3N_4$.

**4.** A mobile radio device equipped with a filter device **characterized by** the characteristic features as claimed in claim 2 or claim 3.

**5.** A transmitter equipped with a filter device **characterized by** the characteristic features as claimed in claim 2 or claim 3.

**6.** A receiver equipped with a filter device **characterized by** the characteristic features as claimed in claim 2 or claim 3.

**7.** A wireless data transmission system equipped with a filter device **characterized by** the characteristic features as claimed in claim 2 or claim 3.

**Revendications**

**1.** Résonateur à ondes de volume, lequel comprend une unité de résonateur et un élément de réflexion (2), dans lequel l'élément de réflexion (2) incorpore plusieurs couches (6, 7, 8) qui, respectivement, contiennent un mélange constitué d'au moins deux matériaux, **caractérisé en ce que,** à l'intérieur de chaque couche (6, 7, 8), la composition du mélange varie relativement par rapport à l'épaisseur de couche de façon continue et périodique.

**2.** Dispositif de filtre équipé d'au moins un résonateur à ondes de volume, qui contient une unité de résonateur et un élément de réflexion (2), **caractérisé par** les caractéristiques de la revendication 1.

**3.** Dispositif de filtre selon la revendication 2, **caractérisé en ce que** l'élément de réflexion (2) contient un mélange de $SiO_2$ et $Ta_2O_5$ ou de $SiO_2$ et $Si_3N_4$.

**4.** Appareil de radio mobile équipé d'un dispositif de filtre, **caractérisé par** les caractéristiques de la revendication 2 ou de la revendication 3.

**5.** Emetteur muni d'un dispositif de filtre, **caractérisé par** les caractéristiques de la revendication 2 ou de la revendication 3.

**6.** Récepteur équipé d'un dispositif de filtre, **caractérisé par** les caractéristiques de la revendication 2 ou de la revendication 3.

**7.** Système de transmission de données sans fil, équipé selon les caractéristiques de la revendication 2 ou de la revendication 3.

# FIG. 1

# FIG. 2

FIG. 3

FIG. 4

FIG. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5646583 A

- EP 609555 A